# EUROPEAN PATENT APPLICATION

(11) **EP 4 693 293 A1**
(43) Date of publication of application: **11.02.2026**
(21) Application number: 25192301.7
(22) Date of filing: 29.07.2025
(51) Int. Cl.: G11C 11/16, G11C 7/04

(54) **MEMORY DEVICE INCLUDING AUXILIARY TRANSISTORS AND METHOD OF OPERATING THE SAME**

(30) Priority: 01.08.2024 KR 20240102688
(71) Applicant: Samsung Electronics Co., Ltd., Suwon-si, Gyeonggi-do 16677 (KR)
(72) Inventor: WON, Sanggyeong, 16677 Suwon-si (KR); KIM, Gyuseong, 16677 Suwon-si (KR)
(74) Representative: Marks & Clerk LLP

(57) **Abstract**

A memory device includes a memory cell array including a plurality of magnetic memory cells connected to a first bitline or a first source line, a plurality of auxiliary transistors connected to the first bitline or the first source line, and connected in parallel to each other, and a control logic circuit connected to a gate electrode of each of the plurality of first auxiliary transistors. The control logic circuit may turn on a first number of auxiliary transistors corresponding to a first wordline, among the plurality of auxiliary transistors, in response to an operation command for a first magnetic memory cell connected to the first wordline.

## Description

### FIELD

Example embodiments relate to a memory device including auxiliary transistors and a method of operating the same.

### BACKGROUND

A magnetic or magnetoresistive random access memory (MRAM) is a memory device storing data using resistance variation of magnetic tunnel junction (MTJ) elements in memory cells. Resistance of an MTJ element varies depending on whether a magnetization direction of a free layer is the same as that of a pinned layer.

The recent trend towards miniaturization in semiconductor memory device manufacturing is driving the demand for smaller, higher-density memory devices including resistive memory cells (for example, MRAM).

However, a difference in electrical paths (or interconnections) between an input/output circuit and each memory cell may cause margins of read and write operations on each memory cell to be reduced.

For example, in a memory cell array including a plurality of memory cells, resistance variations may occur due to a difference in electrical paths between memory cells close to an input/output circuit and memory cells distant from the input/output circuit. This may lead to an operational mismatch between a plurality of memory cells. This may negatively impact performance.

In addition, due to temperature-dependent resistance of metal elements (or interconnections), changes in temperature may reduce read and write margins. This may negatively impact performance.

### SUMMARY

Example embodiments provide a memory device for significantly reducing performance degradation caused by a difference in locations of a magnetic memory cells and/or a difference in temperature-dependencies of the memory device. Example embodiments provide a memory device having improved performance.

According to an example embodiment, a memory device includes a memory cell array including a plurality of magnetic memory cells connected to a plurality of wordlines, a plurality of bitlines, and a plurality of source lines, a plurality of auxiliary transistors connected in parallel between a first bitline of the plurality of bitlines or a first source line of the plurality of source lines and a ground, and a control logic circuit connected to a gate electrode of each of the plurality of first auxiliary transistors. The plurality of magnetic memory cells include a plurality of first magnetic memory cells connected to the plurality of wordlines, the first bitline and the first source line. The control logic circuit may turn on a first number of auxiliary transistors corresponding to a first wordline of the plurality of wordlines, among the plurality of auxiliary transistors, in response to an operation command for a first magnetic memory cell connected to the first wordline, among the plurality of first magnetic memory cells. The memory device may additionally include a row decoder, a column decoder, and/or an input/output driver, as well as a multiplexer; however, these features may be optional.

According to an example embodiment, a method of operating a memory device may include receiving an operation command at the memory device for a first magnetic memory cell connected to a first bitline, a first source line, and a first wordline, turning on a first number of auxiliary transistors, connected in parallel between the first bitline or the first source line and a ground, corresponding to the first wordline, among a plurality of auxiliary transistors, and applying an operation current through the first bitline or the first source line. The turning on the first number of auxiliary transistors may be based on the received operation command. The particular first number of auxiliary transistors to be turned on may be based on the received operation command. The operation current may be a current applied according to the received operation command. The operation current may be a read current or a write current.

According to an example embodiment, a memory device includes a memory cell array including a plurality of magnetic memory cells connected to a plurality of wordlines, a plurality of bitlines and a plurality of source lines, a plurality of auxiliary transistors connected in parallel between a first bitline of the plurality of bitlines or a first source line of the plurality of source lines and a ground, and a control logic circuit connected to a gate electrode of each of the plurality of first auxiliary transistors. The plurality of magnetic memory cells include a plurality of first magnetic memory cells connected to the plurality of wordlines, the first bitline, and the first source line. The control logic circuit may include a voltage generation circuit configured to generate a bias voltage varying depending on a temperature of the memory device. The control logic circuit may provide control signals having the bias voltage to a gate electrode of each of a first number of auxiliary transistors corresponding to a first wordline of the plurality of wordlines, among the plurality of auxiliary transistors, in response to an operation command for a first magnetic memory cell connected to the first wordline, among the plurality of first magnetic memory cells.

While gate electrode is referred to, reference may also be made to gate terminal, or gate. These terms all indicate the same element. While the memory device has been described as comprising a plurality of auxiliary transistors, the transistors may comprise an auxiliary circuit comprising the plurality of auxiliary transistors. However, those skilled in the art will appreciate excluding the auxiliary circuit may not exclude the plurality of auxiliary transistors. The plurality of first magnetic memory cells may be arranged in a column or a row of magnetic memory cells within the memory cell array. The described operation command may include a read command and a write command.

At least some of the above and other features of the disclosure are set out in the claims.

### BRIEF DESCRIPTION OF DRAWINGS

FIG. 1 is a block diagram of a memory system according to an example embodiment.
FIG. 2 is a block diagram of a memory device according to an example embodiment.
FIG. 3 is a circuit diagram of a memory cell array according to an example embodiment.
FIG. 4A is a perspective view of a (1-1)-th magnetic memory cell connected to a first bitline, a first source line, and a first wordline, according to an example embodiment.
FIG. 4B is a diagram illustrating a (1-1)-th magnetic memory cell including a first variable resistance element according to an example embodiment.
FIG. 5 is a diagram illustrating a configuration to detect data stored in a (1-1)-th magnetic memory cell based on a distinction between different resistance states of a first variable resistance element.
FIG. 6 is a diagram illustrating an electrical path in which a first number of first auxiliary transistors are in a turned-on state, according to an example embodiment.
FIG. 7A is a diagram illustrating a configuration to turn on at least a portion of a plurality of first auxiliary transistors in response to an operation request for a (1-1)-th magnetic memory cell, according to an example embodiment.
FIG. 7B is a diagram illustrating a configuration to turning on at least a portion of a plurality of first auxiliary transistors in response to an operation request for a (1-256)-th magnetic memory cells, according to an example embodiment.
FIG. 8 is a block diagram of a memory device including a control logic circuit further including a voltage generation circuit and a low-dropout (LDO) regulator, according to an example embodiment.
FIG. 9 is a circuit diagram of a voltage generation circuit according to an example embodiment.
FIG. 10 is a circuit diagram of a voltage generation circuit according to an example embodiment.
FIG. 11 is a flowchart illustrating a method of operating a memory device according to an example embodiment.
FIG. 12 is a flowchart illustrating a method of turning on at least a portion of a plurality of first auxiliary transistors by a control logic circuit according to an example embodiment.

### DETAILED DESCRIPTION

Hereinafter, example embodiments will be described with reference to the accompanying drawings.

The term "first," "second," or the like used herein may modify various elements regardless of the order and/or priority thereof, and is used only for distinguishing one element from another element, without limiting example embodiments.

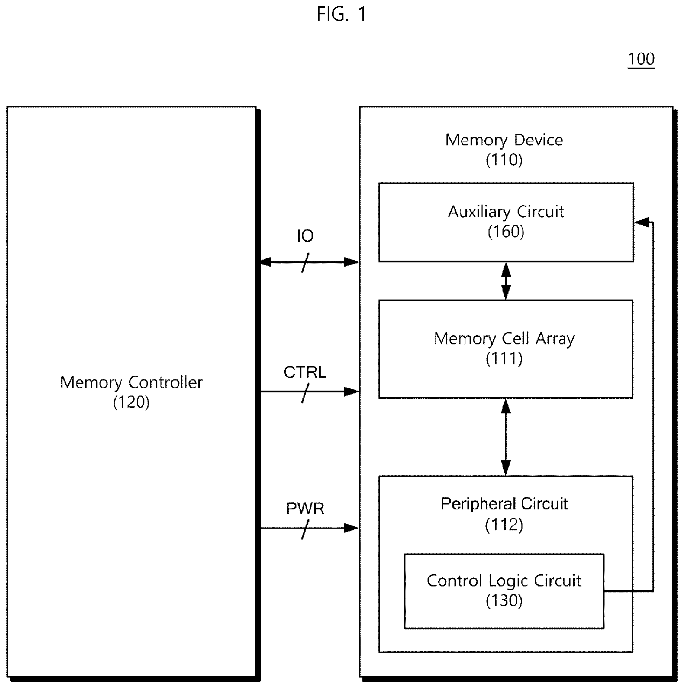

FIG. 1 is a block diagram of a memory system according to an example embodiment.

Referring to FIG. 1, a memory system 100 may include a memory device 110 and a memory controller 120.

The memory device 110 may receive input/output signals IO from the memory controller 120 through input/output lines. The memory device 110 may also receive control signals CTRL(or commands CMD) from the memory controller 120 through control lines. The memory device 110 may perform the decoding operation based on the control signals CTRL such as a chip select signal /CS, a row address strobe signal /RAS, a column address strobe signal CAS/, a write enable signal /WE, and a clock enable signal CKE. After the decoding operation is completed, the memory device 110 may be controlled to perform the commands CMD from the memory controller. In addition, the memory device 110 may be supplied with external power PWR from the memory controller 120 through power lines.

The memory system 100 may store data in the memory device 110 under the control of the memory controller 120.

The memory device 110 may include a memory cell array 111, a peripheral circuit 112, and an auxiliary circuit 160. Those skilled in the art will appreciate one or more of these elements may be omitted. For example, the peripheral circuit 112 may be omitted.

The memory cell array 111 according to an example embodiment may have a two-dimensional structure or a vertical three-dimensional structure. The memory cell array 111 may include a plurality of memory cells. Single-bit data or multi-bit data may be stored in each memory cell.

According to an example embodiment, the memory cell array 111 may be disposed next to or above the peripheral circuit 112 in terms of the design layout structure. A structure, in which the memory cell array 111 is disposed above the peripheral circuit 112, may be referred to as a cell-on-peripheral (COP) structure. In an embodiment, the memory cell array 111 and the peripheral circuit 112 may be manufactured as separate chips. An upper chip including the memory cell array 111 and a lower chip including the peripheral circuit 112 may be connected to each other by a bonding method. Such a structure may be referred to as a chip-to-chip (C2C) structure.

According to an example embodiment, the auxiliary circuit 160 may include a plurality of auxiliary transistors. For example, the auxiliary circuit 160 may include a plurality of auxiliary transistors connected to at least a portion of the plurality of memory cells included in the memory cell array 111.

The peripheral circuit 112 may include analog or digital circuits required to store data in the memory cell array 111 or read data stored in the memory cell array 111. The peripheral circuit 112 may be supplied with external power PWR through power lines and generate various levels of internal powers.

The peripheral circuit 112 may receive commands, addresses, and data from the memory controller 120 through input/output lines. In some examples, the peripheral circuit 112 may receive commands and addresses from the memory controller 120 through the control lines. Also, the peripheral circuit 112 may store data in the memory cell array 111 according to the control signals CTRL. Also, the peripheral circuit 112 may read data stored in the memory cell array 111 and provide the read data to the memory controller 120.

According to an example embodiment, the peripheral circuit 112 may include a control logic circuit 130. Those skilled in the art will appreciate that while the control logic circuit 130 is described as forming part of the peripheral circuit 112, the memory device 110 may comprise the control logic circuit 130 without the remainder of the peripheral circuit 112. Accordingly, the memory device 110 may comprise the memory cell array 111, the auxiliary circuit 160, and the control logic circuit 130.

The control logic circuit 130 may execute software or a program to control at least one other component (for example, the memory cell array 111 and/or the auxiliary circuit 160) of the memory device 110 and perform various data processing or computation. The control logic circuit 130 may include a central processing unit, a microprocessor, or the like, and may control the overall operation of the memory device 110. Accordingly, operations performed by the memory device 110 may be understood as being performed under the control of the control logic circuit 130.

According to an example embodiment, the control logic circuit 130 may include an algorithm for controlling the auxiliary circuit 160. For example, the algorithm may be software code programmed within the control logic circuit 130. For example, the algorithm may be hardcoded within the control logic circuit 130, but example embodiments are not limited thereto.

The control logic circuit 130 may control at least a portion of the plurality of auxiliary transistors included in the auxiliary circuit 160 based on the algorithm.

The control logic circuit 130 according to an example embodiment may turn on at least a portion of the plurality of auxiliary transistors included in the auxiliary circuit 160 in response to a read or write command for a specific (or selected) memory cell included in the memory cell array 111.

For example, the control logic circuit 130 may turn on the number of auxiliary transistors corresponding to a wordline connected to a specific (or selected) memory cell in response to a read or write command for the specific memory cell.

In example embodiments, the control logic circuit 130 may provide control signals CTRL2 having a power supply voltage VDD to turn on the number of auxiliary transistors. For example, the control signals CTRL2 having the power supply voltage VDD may be generated based on the read or write command and the address from the memory controller 120.

As a result, the memory device 110 according to an example embodiment may reduce a variation in an electrical path (or resistance) caused by the arrangement of memory cells. Furthermore, the memory device 110 may significantly reduce performance degradation caused by a difference in locations of the memory cells included in the memory cell array 111.

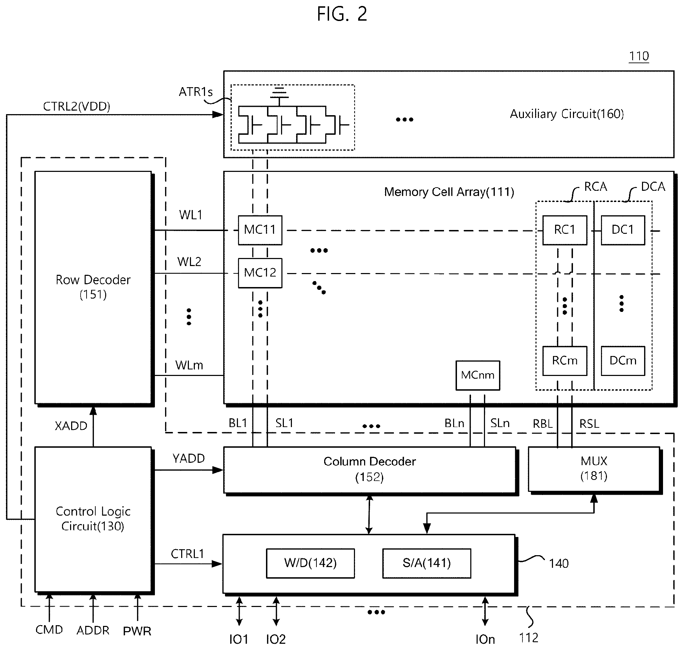

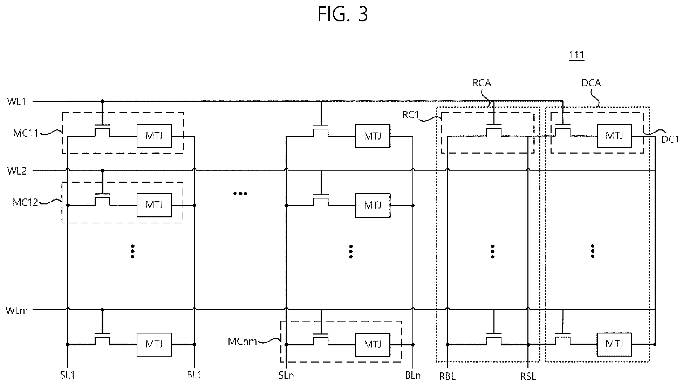

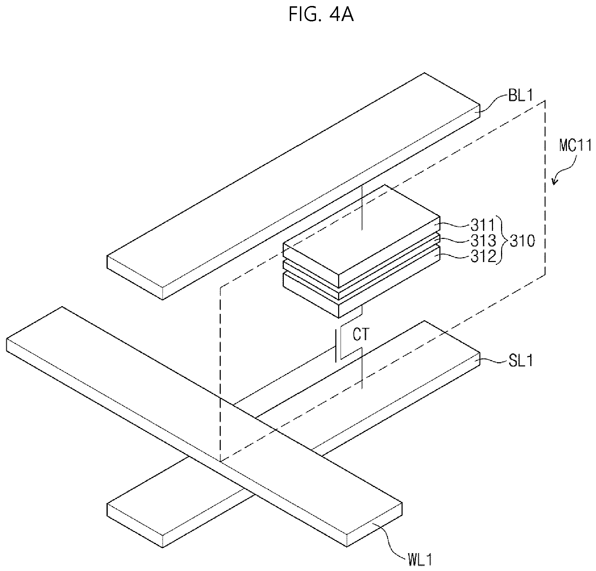

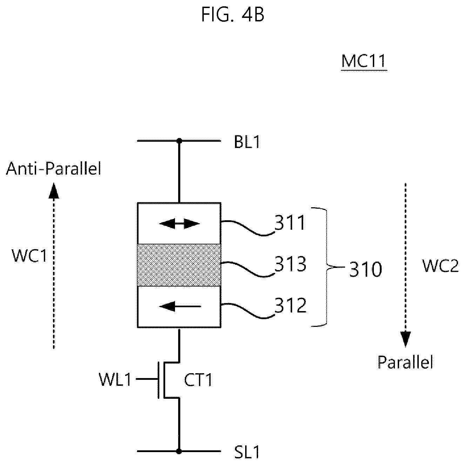

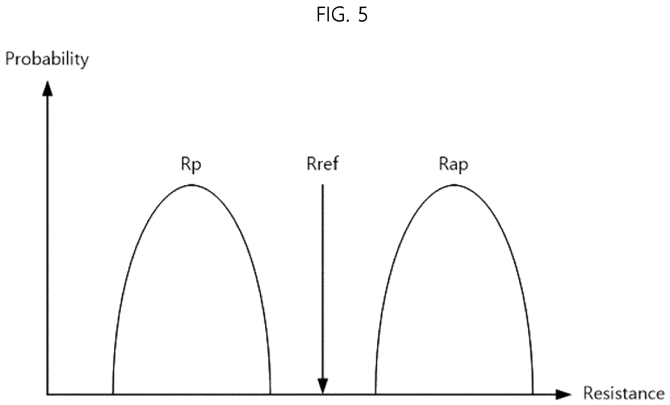

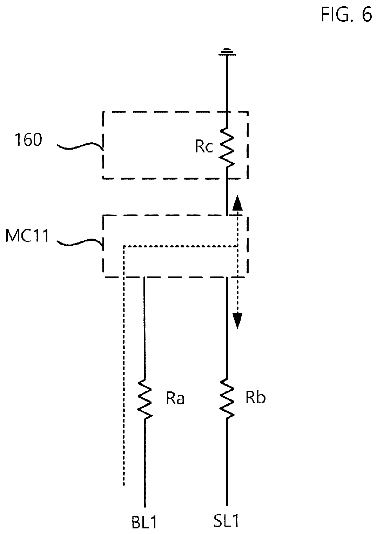

FIG. 2 is a block diagram of a memory device according to an example embodiment. FIG. 3 is a circuit diagram of a memory cell array according to an example embodiment. FIG. 4A is a perspective view of a (1-1)-th magnetic memory cell connected to a first bitline, a first source line, and a first wordline, according to an example embodiment. FIG. 4B is a diagram illustrating a (1-1)-th magnetic memory cell including a first variable resistance element according to an example embodiment. FIG. 5 is a diagram illustrating a configuration to detect data stored in a (1-1)-th magnetic memory cell based on a distinction between different resistance states of a first variable resistance element. FIG. 6 is a diagram illustrating an electrical path in which a first number of first auxiliary transistors are in a turned-on state, according to an example embodiment.

Referring to FIGS. 1 and 2, the memory device 110 may include the memory cell array 111, the peripheral circuit 112, and the auxiliary circuit 160. According to an example embodiment, the peripheral circuit 112 may include a row decoder 151, a column decoder 152, an input/output driver 140, and the control logic circuit 130. While not illustrated in FIG. 2, the memory device 110 may include the memory cell array 111, and the control logic circuit 130. The row decoder 151, column decoder 152, and/or input/output driver 140, as well as a multiplexer 181 may not be necessary for achieving the noted technical effect.

The memory cell array 111 may include nonvolatile memory cells. For example, the memory cell array 111 may include a plurality of magnetic memory cells MC11 and MC12 to MCnm including resistive memory cells such as phase change random access memory (PRAM) or resistance random access memory (RRAM) cells, or other types of memory cells including nano floating gate memory (NFGM), polymer random access memory (PoRAM), magnetic random access memory (MRAM), or ferroelectric random access memory (FRAM) cells.

According to an example embodiment, the memory cell array 111 may include a plurality of magnetic memory cells MC11 and MC12 to MCnm (where m and n are each positive integers) arranged in a matrix of rows and columns.

The plurality of magnetic memory cells MC11 and MC12 to MCnm may be connected to each of a plurality of wordlines WL1 to WLm, each of a plurality of bitlines BL1 to BLn, and each of a plurality of source lines SL1 to SLn. Each of the plurality of magnetic memory cells MC11 and MC12 to MCnm may be connected to one of the plurality of wordlines WL1 to WLm, one of the plurality of bitlines BL1 to BLn, and one of the plurality of source lines SL1 to SLn.

In addition, the memory cell array 111 may include a reference cell area RCA including a plurality of reference cells RC1 to RCm. For example, the memory cell array 111 may include a plurality of reference cells RC1 to RCm connected to a reference bitline RBL and a reference source line RSL.

In addition, the memory cell array 111 may include a dummy cell area DCA including a plurality of dummy cells DC1 to DCm. For example, the memory cell array 111 may include a plurality of dummy cells DC1 to DCm, respectively connected to the plurality of reference cells RC1 to RCm. For example, the first dummy cell DC1 may be connected to the first reference cell RC1. However, the dummy cell area DCA or the plurality of dummy cells DC1 to DCm may be omitted in the configuration of the memory cell array 111 according to another embodiment.

For example, referring to FIG. 3, the memory cell array 111 according to an example embodiment may include a plurality of magnetic memory cells MC11 and MC12 to MCnm connected to corresponding bitlines and source lines, among the plurality of bitlines BL1 to BLn and the plurality of source lines SL1 to SLn. In addition, each of the plurality of magnetic memory cells MC11 and MC12 to MCnm may be connected to one of the plurality of wordlines WL1 to WLm.

For example, the (1-1)-th magnetic memory cell MC11 may be connected to the first bitline BL1, the first source line SL1, and the first wordline WL1. In addition, the (1-2)-th magnetic memory cell MC12 may be connected to the first bitline BL1, the first source line SL1, and the second wordline WL2.

Each of the plurality of reference cells RC1 to RCm may include a transistor connected between the reference bitline RBL and the reference source line RSL.

For example, each of the plurality of reference cells RC1 to RCm may be understood as having substantially the same configuration as the configuration in which a variable resistor element is omitted from each of the plurality of magnetic memory cells MC11 and MC12 to MCnm.

Each of the plurality of dummy cells DC1 to DCm may include a transistor and a variable resistor element connected to the transistor.

Referring to FIG. 4A, the (1-1)-th magnetic memory cell MC11 according to an example embodiment may include a cell transistor CT and a first variable resistor element 310.

According to an example embodiment, one end of the cell transistor CT may be connected to the first source line SL1, and the other end of the cell transistor CT may be connected to one end of the variable resistor element 310. A gate electrode, which may also be referred to as a gate terminal or gate, of the cell transistor CT may be connected to the first wordline WL1. The other end of the first variable resistor element 310 may be connected to the first bitline BL1.

According to an example embodiment, the first variable resistor element 310 may include a first magnetic layer 311 and a second magnetic layer 312. Also, the first variable resistor element 310 may include a tunnel layer 313 disposed between the first magnetic layer 311 and the second magnetic layer 312.

A magnetization direction of the second magnetic layer 312 may be fixed. Also, a magnetization direction of the first magnetic layer 311 may be the same as or opposite to the magnetization direction of the second magnetic layer 312 depending on conditions.

Therefore, for example, the first magnetic layer 311 may be referred to as a free layer, and the second magnetic layer 312 may be referred to as a pinned layer or a fixed layer.

The control logic circuit 130 according to an example embodiment may apply a write current through the first bitline BL1 or the first source line SL1 to store data in the (1-1)-th magnetic memory cell MC11.

During the write operation of the (1-1)-th magnetic memory cell MC11, the magnetization direction of the first magnetic layer 311 may be changed depending on a direction of write currents WC1 and WC2 flowing through the first variable resistor element 310.

For example, referring to FIG. 4B, when a current flows from the first source line SL1 to the first bitline BL1, similarly to the first write current WC1, the magnetization direction of the first magnetic layer 311 may be opposite to a magnetization direction of the second magnetic layer 312. Such a state may be referred to as an anti-parallel (ap) state.

When a current flows from the first bitline BL1 to the first source line SL1, similarly to the second write current WC2, the magnetization direction of the first magnetic layer 311 may be the same as the magnetization direction of the second magnetic layer 312. Such a state may be referred to as a parallel (p) state.

Referring to FIG. 5, when the first variable resistor element 310 is in an anti-parallel state, the first variable resistor element 310 may have an anti-parallel resistance Rap. When the first variable resistor element 310 is in a parallel state, the first variable resistor element 310 may have a parallel resistance Rp.

The memory device 110 (or the control logic circuit 130) may distinguish between data "0" and data "1" using the magnitude of a resistance during a read operation.

The control logic circuit 130 may apply a logic high voltage to the first wordline WL1 during a read operation on the (1-1)-th magnetic memory cell MC11. The cell transistor CT may be turned on in response to the logic high voltage applied to the first wordline WL1.

In addition, the control logic circuit 130 may apply a read current to the first bitline BL1 toward the first source line SL1 to measure the resistance value of the first variable resistor element 310.

The control logic circuit 130 may compare the measured resistance value of the first variable resistor element 310 with a reference resistance Rref to determine the data stored in the first variable resistor element 310 (or the (1-1)-th magnetic memory cell MC11).

The reference resistance Rref may be changed externally without using a fixed value as it is during the manufacturing of the memory device 110. The reference resistance Rref may be determined through a test operation.

Referring FIGS. 3 and 4, according to an example embodiment, the control logic circuit 130 may determine the reference resistance Rref using at least a portion of the plurality of reference cells RC1 to RCm.

For example, the control logic circuit 130 may apply a read current to the first reference cell RC1 through the reference bitline RBL in response to a read command (or request) for the (1-1)-th magnetic memory cell MC11. Furthermore, the control logic circuit 130 may obtain a current, output from the first reference cell RC1, through the reference source line RSL.

The control logic circuit 130 may determine the reference resistance Rref based on the current output from the first reference cell RC1 through the reference source line RSL.

For example, when the magnetization direction of the first magnetic layer 311 is parallel to the magnetization direction of the second magnetic layer 312, the first variable resistor element 310 may have a parallel resistance Rp lower than the reference resistance Rref. The control logic circuit 130 may read data "0" from the first variable resistor element 310.

For example, when the magnetization direction of the first magnetic layer 311 is opposite to the magnetization direction of the second magnetic layer 312, the first variable resistor element 310 may have an anti-parallel resistance Rap higher than the reference resistance Rref. The control logic circuit 130 may read data "1" from the first variable resistor element 310.

Accordingly, the first variable resistor element 310 may be referred to as a magnetic tunnel junction (MTJ) element. In addition, the (1-1)-th magnetic memory cell MC11 may be referred to as an MRAM cell.

In FIG. 4B, the first magnetic layer 311 and the second magnetic layer 312 of the first variable resistor element 310 are illustrated as horizontal magnetic elements, but example embodiments are not limited thereto. For example, the first magnetic layer 311 and the second magnetic layer 312 may be implemented as vertical magnetic elements.

Referring again to FIG. 2, the memory device 110 may include the row decoder 151 selecting at least a portion of the plurality of wordlines WL1 to WLm.

For example, the row decoder 151 may decode the row address XADD to activate a corresponding wordline among the plurality of wordlines WL1 to WLm.

For example, the row decoder 151 may further include a plurality of wordline drivers, respectively connected to the plurality of wordlines WL1 to WLm. Alternatively, the plurality of wordline drivers may be implemented as a configuration, separate from the row decoder 151, to be connected to the row decoder 151 and the plurality of wordlines WL1 to WLm.

In addition, the memory device 110 may include the column decoder 152 selecting at least a portion of corresponding bitlines and source lines from among the plurality of bitlines BL1 to BLn and the plurality of source lines SL1 to SLn.

For example, the column decoder 152 may decode the column address YADD to activate (or select) corresponding bitlines and source lines among the plurality of bitlines BL1 to BLn and the plurality of source lines SL1 to SLn.

In addition, the memory device 110 may include a multiplexer 181 connected to the reference bitline RBL and the reference source line RSL.

For example, the multiplexer 181 may transmit a current, transmitted from the input/output driver 140, to at least a portion of the plurality of reference cells RC1 to RCm through the reference bitline RBL or the reference source line RSL.

In addition, the memory device 110 may include the input/output driver 140 writing data in the memory cell array 111 or reading data from the memory cell array 111, based on control signals CTRL1. For example, the control logic circuit 130 may generate the control signals CTRL1 based on the commands and addresses.

The input/output driver 140 may be internally connected to the column decoder 152 through data lines, and may be externally connected to the memory controller 120 (see FIG. 1) through input/output lines IO1 to IOn.

The input/output driver 140 may receive program data from the memory controller 120 during a program (or write) operation.

The input/output driver 140 may provide data, read from the memory cell array 111, to the memory controller 120 during a read operation.

The input/output driver 140 according to an example embodiment may include a sense amplifier (S/A) 141 and a write driver (W/D) 142.

According to an example embodiment, the sense amplifier 141 may detect a difference between a voltage of a source line (for example, the first source line SL1) and a reference voltage during a read operation. Thus, the sense amplifier 141 may read data stored in a selected magnetic memory cell.

The reference voltage may be provided from a reference voltage generation circuit. The sense amplifier 141 may operate in response to the control signals CTRL1 provided from the control logic circuit 130.

The sense amplifier 141 may compare the reference resistance Rref with a resistance of a magnetic memory cell during a read operation to read the data stored in the selected magnetic memory cell.

The reference resistance Rref may be determined by the current output through the reference source line RSL as a read current is applied to at least a portion of the plurality of reference cells RC1 to RCm through the reference bitline RBL.

The write driver 142 may receive the control signals CTRL1 from the control logic circuit 130 and provide a write current to the column decoder 152. The write current may be understood to program the selected memory cell into one of a plurality of states.

The write driver 142 may provide one or more write currents based on a multi-state of the selected memory cell during a program (or write) operation.

The control logic circuit 130 may control the read and/or write operations of the memory device 110 using commands CMD, addresses ADDR, and external power PWR provided from the memory controller 120. The addresses ADDR may include a row address for selecting a single memory cell or a single wordline and a column address for selecting a single memory cell.

The memory device 110 may include the auxiliary circuit 160 including a plurality of auxiliary transistors.

According to an example embodiment, the auxiliary circuit 160 may include the plurality of auxiliary transistors connected to corresponding bitlines or source lines among the plurality of bitlines BL1 to BLn and the plurality of source lines SL1 to SLn.

The auxiliary circuit 160 may include a plurality of first auxiliary transistors ATR1s connected to the first bitline BL1 or the first source line SL1. For example, in a read operation, the plurality of first auxiliary transistors ATR1s may be connected to the first bitline BL1 and in a write operation, the plurality of first auxiliary transistors ATR1s may be connected to the first bitline BL1 or the first source line SL1.

The plurality of first auxiliary transistors ATR1s may be connected in parallel to each other between the first bitline BL1 or the first source line SL1 and a ground (or a ground voltage VSS). For example, each of the plurality of first auxiliary transistors ATR1s may be referred to as an N-channel metal-oxide-semiconductor (NMOS) transistor.

In example embodiments, the plurality of first auxiliary transistors ATR1s may be connected to the first bitline BL1 or the first source line SL1 by a switch (not shown). For example, in a read operation, the plurality of first auxiliary transistors ATR1s may be connected to the first bitline BL1 through a first switch (not shown) and in a write operation, the plurality of first auxiliary transistors ATR1s may be connected to the first bitline BL1 through the first switch or the plurality of first auxiliary transistors ATR1s may be connected to the first source line SL1 through a second switch.

According to an example embodiment, the control logic circuit 130 may turn on the number of auxiliary transistors corresponding to a wordline, connected to a specific magnetic memory cell, in response to an operation command for the specific magnetic memory cell. The control logic circuit 130 may control operation of one or more switches connecting the number of auxiliary transistors to bitlines of the plurality of bitlines, and/or one or more switches connecting the number of auxiliary transistors to source lines of the plurality of source lines. For example, the control logic circuit 130 may control the first switch to connect (or disconnect) the plurality of first auxiliary transistors ATR1s to the first bitline BL1, and/or control the second switch to connect (or disconnect) the plurality of first auxiliary transistors ATR1s to the first source line SL1.

For example, the control logic circuit 130 may identify a wordline, a bitline, and a source line activated according to the operation command, based on an address ADDR included in the operation command.

Furthermore, the control logic circuit 130 may turn on the number of auxiliary transistors, corresponding to the identified wordline, among the plurality of auxiliary transistors connected to the identified bitline and source line.

For example, the control logic circuit 130 may identify the first wordline WL1, the first bitline BL1, and the first source line SL1, connected to the (1-1)-th magnetic memory cell MC11, in response to a write command for the (1-1)-th magnetic memory cell MC11.

Furthermore, the control logic circuit 130 may turn on a first number of the first auxiliary transistors corresponding to the first wordline WL1, among the plurality of first auxiliary transistors ATR1s connected to the first bitline BL1 and the first source line SL1.

Referring to FIG. 6 together, when a first number of the first auxiliary transistors according to an example embodiment are turned on, a resistance of an electrical path, through which an operation current is applied to the (1-1)-th magnetic memory cell MC11, may be decreased.

For example, the first bitline BL1 may have a first resistance value Ra. Also, the first source line SL1 may have a second resistance value Rb. Also, a first number of turned-on first auxiliary transistors may have a third resistance value Rc.

When the first number of first auxiliary transistors are turned on, a representative resistor of the first source line SL1 and a representative resistor of the first auxiliary transistors may be connected in parallel in the electrical path through which the operation current flows.

Accordingly, in an example embodiment, a resistance for the operation current is significantly lower when the first auxiliary transistors are turned on than when the first auxiliary transistors are turned off.

The control logic circuit 130 may apply a driving voltage through the first wordline WL1 while the first number of first auxiliary transistors are turned on. Also, the control logic circuit 130 may apply an operation current to the first bitline BL1 or the first source line SL1 while the first number of first auxiliary transistors are turned on.

Referring to the above-described configuration, the control logic circuit 130 may turn on the auxiliary transistor connected to a specific magnetic memory cell, a bitline, or a source line in response to an operation command for the specific magnetic memory cell.

As a result, the control logic circuit 130 may decrease the resistance of the electrical path connected from the input/output driver 140 to each magnetic memory cell. For example, the control logic circuit 130 may significantly reduce performance degradation caused by the resistance of the electrical path connected from the input/output driver 140 to each magnetic memory cell. The control logic circuit 130 may improve performance.

For example, the control logic circuit 130 may identify the second wordline WL2, the first bitline BL1, and the first source line SL1, connected to the (1-2)-th magnetic memory cell MC12, in response to a write command for the (1-2)-th magnetic memory cell MC12.

Furthermore, the control logic circuit 130 may turn on a second number of first auxiliary transistors, corresponding to the second wordline WL2 and smaller than the first number, among the plurality of first auxiliary transistors ATR1s connected to the first bitline BL1 and the first source line SL1.

The resistance along the electrical path from the input/output driver 140 to the (1-1)-th magnetic memory cell MC11 may be referred to as being higher than the resistance along the electrical path from the input/output driver 140 to the (1-2)-th magnetic memory cell MC12.

Referring to the above-described configuration, the control logic circuit 130 may turn on the number of auxiliary transistors corresponding to a wordline, among the auxiliary transistors connected to a specific magnetic memory cell, in response to an operation command for the specific magnetic memory cell.

For example, the control logic circuit 130 may turn on a different number of auxiliary transistors based on the resistance of the electrical path connected from the input/output driver 140 to each magnetic memory cell.

Accordingly, the memory device 110 according to an example embodiment may significantly reduce variations in operational performance caused by a difference in locations of magnetic memory cells. As a result, the control logic circuit 130 may significantly reduce performance degradation of the memory device 110 caused by the difference in locations of the magnetic memory cells.

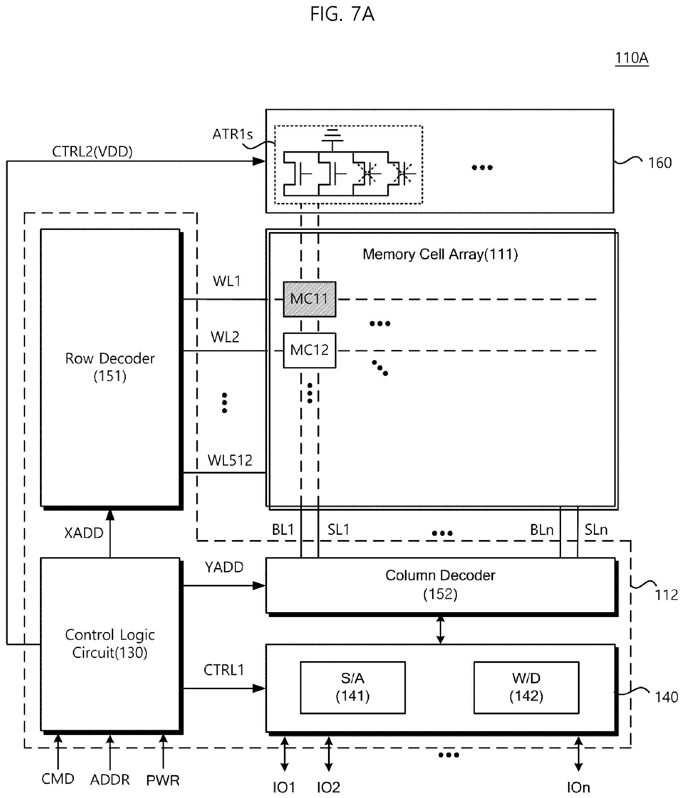

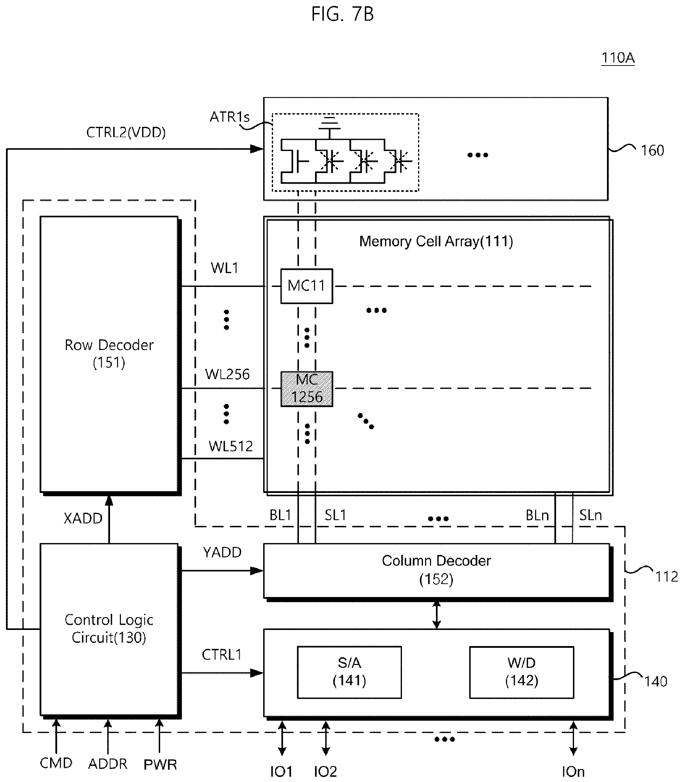

FIG. 7A is a diagram illustrating a configuration to turn on at least a portion of a plurality of first auxiliary transistors in response to an operation request for a (1-1)-th magnetic memory cell, according to an example embodiment. FIG. 7B is a diagram illustrating a configuration to turning on at least a portion of a plurality of first auxiliary transistors in response to an operation request for a (1-256)-th magnetic memory cells, according to an example embodiment.

Referring to FIGS. 7A and 7B, a control logic circuit 130 according to an example embodiment may turn on the number of auxiliary transistors corresponding to each wordline, in response to an operation command for a magnetic memory cell connected to different wordlines.

The memory device 110A illustrated in FIGS. 7A and 7B may be understood as an example of the memory device 110 illustrated in FIG. 2. Similarly to the memory device 110 illustrated in FIG. 2, the memory device 110A illustrated in FIGS. 7A and 7B may further include a reference cell area RCA and a dummy cell area DCA.

For example, the same or substantially the same components are represented by the same reference numerals, and redundant descriptions will be omitted to avoid repetition.

According to an example embodiment, the auxiliary circuit 160 may include a plurality of auxiliary transistors connected to at least a portion of bitlines and source lines corresponding to each other, among the plurality of bitlines BL1 to BLn and the plurality of source lines SL1 to SLn.

Among the plurality of auxiliary transistors, auxiliary transistors connected to the same bitline and source line may be connected in parallel to each other.

For example, the auxiliary circuit 160 may include a plurality of first auxiliary transistors ATR1s connected to a first bitline BL1 and a first source line SL1. The plurality of first auxiliary transistors ATR1 s may be connected in parallel to each other between the first bitline BL1 or the first source line SL1 and the ground.

For example, the auxiliary circuit 160 may include four first auxiliary transistors ATR1s connected in parallel between the first bitline BL1 or the first source line SL1 and the ground.

Each of the plurality of wordlines WL1 to WL512 may correspond to at least one of the first auxiliary transistors ATR1s. For example, each of the plurality of wordlines WL1 to WL512 may correspond to at least one first auxiliary transistor among the first auxiliary transistors ATR1s.

According to an example embodiment, the plurality of wordlines WL1 to WL512 may be divided into a plurality of wordline groups, each including at least one wordline.

The number of the plurality of wordline groups may correspond to the number of auxiliary transistors connected to each bitline and source line.

For example, when four first auxiliary transistors ATR1s are connected to the first bitline BL1 and the first source line SL1, the plurality of wordlines WL1 to WL512 may be divided into four wordline groups.

For example, the plurality of wordlines WL1 to WL512 may include a first wordline group including the first wordline WL1 to the 128th wordline WL128. For example, the plurality of wordlines WL1 to WL512 may include a second wordline group including the 129th wordline WL129 to the 256th wordline WL256. For example, the plurality of wordlines WL1 to WL512 may include a third wordline group including the 257th wordline WL257 to the 384th wordline WL384. For example, the plurality of wordlines WL1 to WL512 may include a fourth wordline group including the 385th wordline WL385 to the 512th wordline WL512.

Furthermore, each wordline group, or wordlines included in each wordline group, may correspond to the number of the first auxiliary transistors ATR1s that is turned on.

For example, each of the first wordline WL1 to the 128th wordline WL128 may correspond to one of the first auxiliary transistors ATR1s. For example, each of the 129th wordline WL129 to the 256th wordline WL256 may correspond to two of the first auxiliary transistors ATR1s. For example, each of the 257th wordline WL257 to the 384th wordline WL384 may correspond to three of the first auxiliary transistors ATR1s. For example, each of the 385th wordline WL385 to the 512th wordline WL512 may correspond to four of the first auxiliary transistors ATR1s.

However, the number of wordlines, the number of first auxiliary transistors ATR1s connected in parallel, the number of wordline groups, and the number of first auxiliary transistors ATR1s corresponding to each wordline group are merely examples, and the configuration of the present disclosure is not limited thereto.

In addition, the number of first auxiliary transistors ATR1s that is turned on corresponding to each wordline may be pre-stored in an internal storage space of the memory system 100 (or the memory device 110A).

For example, the number of first auxiliary transistors ATR1s corresponding to each of the plurality of wordlines WL1 to WL512 may be stored in a storage space in the memory system 100 in the form of a lookup table.

According to an example embodiment, the control logic circuit 130 may turn on the number of auxiliary transistors corresponding to a wordline connected to a specific magnetic memory cell, in response to an operation command for the specific magnetic memory cell.

For example, the control logic circuit 130 may identify a wordline, a bitline, and a source line activated according to the operation command, based on the address ADDR included in the operation command.

Furthermore, the control logic circuit 130 may turn on the number of auxiliary transistors corresponding to the identified wordline, among the plurality of auxiliary transistors connected to the identified bitline and source line.

The control logic circuit 130 may provide the control signal CTRL2 having the power supply voltage VDD to a gate electrode, which may be referred to as a gate terminal or gate, of each of the number of auxiliary transistors corresponding to the identified wordline.

Referring to FIG. 7A, according to an example embodiment, the control logic circuit 130 may identify the first wordline WL1, the first bitline BL1, and the first source line SL1 connected to the (1-1)-th magnetic memory cell MC11 in response to a write command for the (1-1)-th magnetic memory cell MC11.

Furthermore, the control logic circuit 130 may turn on a first number of the first auxiliary transistors corresponding to the first wordline WL1, among the plurality of first auxiliary transistors ATR1s connected to the first bitline BL1 and the first source line SL1.

For example, the control logic circuit 130 may turn on two first auxiliary transistors corresponding to the first wordline WL1, among the plurality of first auxiliary transistors ATR1s, in response to a write command for the (1-1)-th magnetic memory cell MC11.

Referring to FIG. 7B, according to an example embodiment, the control logic circuit 130 may identify the 256th wordline WL256, the first bitline BL1, and the first source line SL1, connected to a (1-256)-th magnetic memory cell MC1256, in response to a write command for the (1-256)-th magnetic memory cell MC1256.

Furthermore, the control logic circuit 130 may turn on a second number of first auxiliary transistors corresponding to the 256th wordline WL256, among the plurality of first auxiliary transistors ATR1s connected to the first bitline BL1 and the first source line SL1.

For example, the control logic circuit 130 may turn on a single first auxiliary transistor corresponding to the 256th wordline WL256, among the plurality of first auxiliary transistors ATR1s, in response to a write command for the (1-256)-th magnetic memory cell MC1256

The resistance along the electrical path from the input/output driver 140 to the (1-1)-th magnetic memory cell MC11 may be referred to as being higher than the resistance along the electrical path to the (1-256)-th magnetic memory cell MC1256.

For example, the control logic circuit 130 may turn on a relatively large number of first auxiliary transistors in response to an operation command for a magnetic memory cell having a relatively high resistance along the electrical path connected from the input/output driver 140.

The control logic circuit 130 may turn on a relatively small number of first auxiliary transistors in response to an operation command for a magnetic memory cell having a relatively low resistance along the electrical path connected from the input/output driver 140.

As a result, the memory device 110A according to an example embodiment may reduce a variation in resistance caused by a difference in location of each magnetic memory cell and an electrical distance from the input/output driver 140.

Each of the plurality of wordlines WL1 to WL512 may correspond to a specified number of first auxiliary transistors ATR1s that is turned on based on the magnitude of the resistance along the electrical path connected from the input/output driver 140 to the magnetic memory cell connected to each wordline.

Referring to the above-described configuration, the control logic circuit 130 may turn on the number of auxiliary transistors corresponding to a wordline, among the auxiliary transistors connected to a specific magnetic memory cell, in response to an operation command for the specific magnetic memory cell.

For example, the control logic circuit 130 may turn on a different number of auxiliary transistors according to the resistance of the electrical path connected from the input/output driver 140 to each magnetic memory cell.

Accordingly, the memory device 110A according to an example embodiment may significantly reduce a variation in operational performance caused by a difference in locations of the magnetic memory cells. As a result, the control logic circuit 130 may significantly reduce performance degradation of the memory device 110A caused by the difference in the locations of the magnetic memory cells.

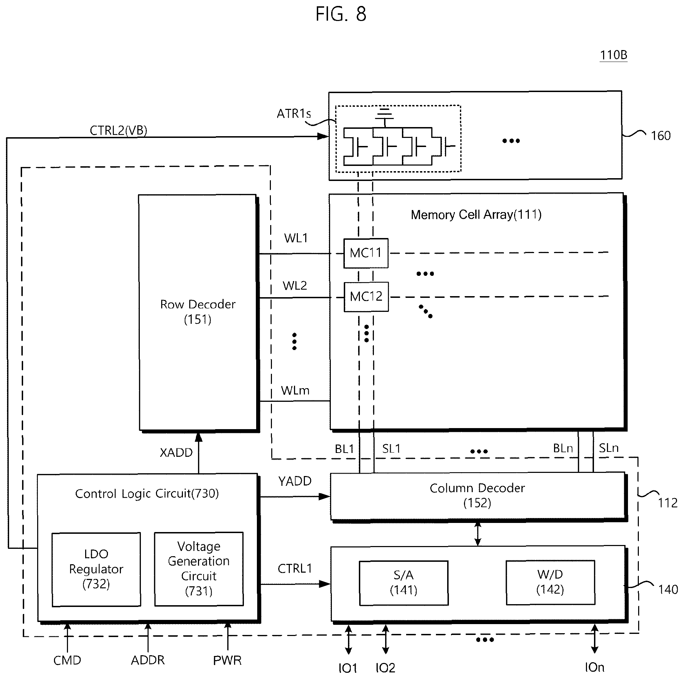

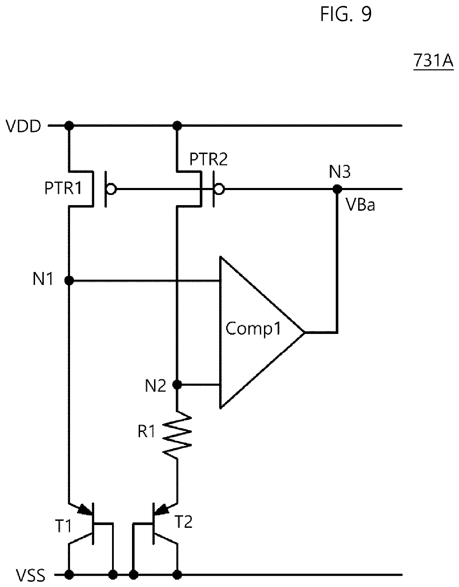

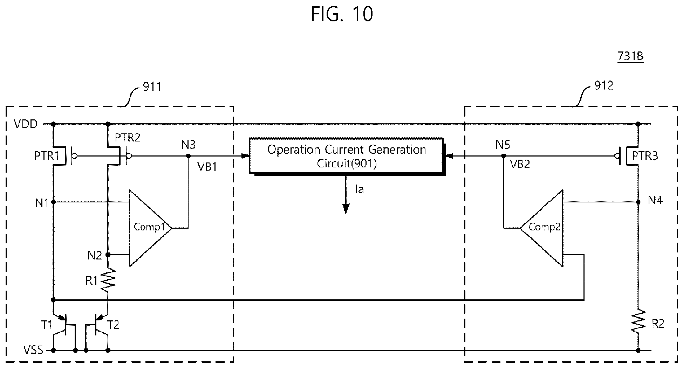

FIG. 8 is a block diagram of a memory device including a control logic circuit further including a voltage generation circuit and a low-dropout (LDO) regulator, according to an example embodiment. FIG. 9 is a circuit diagram of a voltage generation circuit according to an example embodiment. FIG. 10 is a circuit diagram of a voltage generation circuit according to an example embodiment.

Referring to FIG. 8, a memory device 110B may include a memory cell array 111, a peripheral circuit 112, and an auxiliary circuit 160. According to an example embodiment, the peripheral circuit 112 may include a row decoder 151, a column decoder 152, an input/output driver 140, and a control logic circuit 730.

The memory device 110B illustrated in FIG. 8 may be understood as an example of the memory device 110 illustrated in FIG. 2. According to an example embodiment, the memory device 110B illustrated in FIG. 8 may further include a reference cell area RCA and a dummy cell area DCA as in the memory device 110 illustrated in FIG. 2.

Therefore, the same or substantially the same components are represented by the same reference numerals, and redundant descriptions will be omitted to avoid repetition.

According to an example embodiment, the control logic circuit 730 may turn on the number of auxiliary transistors, corresponding to a wordline connected to a specific magnetic memory cell, in response to an operation command for the specific magnetic memory cell.

For example, the control logic circuit 730 may turn on a first number of the first auxiliary transistors ATR1s, among a plurality of first auxiliary transistors ATR1s corresponding to a first wordline WL1, in response to a write command for the (1-1)-th magnetic memory cell MC11

For example, the control logic circuit 730 may turn on a second number of first auxiliary transistors ATR1s, among a plurality of first auxiliary transistors ATR1s corresponding to a second wordline WL2, in response to a write command for a (1-2)-th magnetic memory cell MC12.

A resistance along an electrical path from an input/output driver 140 to a (1-1)-th magnetic memory cell MC11 may be referred to as being higher than a resistance along an electrical path from the input/output driver 140 to a (1-2)-th magnetic memory cell MC12. The second number may be referred to as being smaller than the first number.

Referring to the above-described configuration, the control logic circuit 730 may turn on the number of auxiliary transistors corresponding to a wordline, among auxiliary transistors connected to a specific magnetic memory cell, in response to an operation command for the specific magnetic memory cell.

The control logic circuit 730 may turn on a relatively large number of first auxiliary transistors in response to an operation command for a magnetic memory cell having a relatively high resistance along the electrical path connected from the input/output driver 140.

Accordingly, the memory device 110B according to an example embodiment may significantly reduce a variation in operational performance caused by a differences in locations of magnetic memory cells. As a result, the control logic circuit 130 may significantly reduce performance degradation of the memory device 110B caused by a difference in the locations of the magnetic memory cells.

According to an example embodiment, the control logic circuit 730 may include a voltage generation circuit 731 and a low-dropout (LDO) regulator 732.

In example embodiments, the voltage generation circuit 731 and the low-dropout (LDO) regulator 732 may be included in the peripheral circuit 112 outside the control logic circuit 730.

The voltage generation circuit 731 may generate a bias voltage VB, varying depending on a temperature of the memory device 110B. For example, the temperature of the memory device 110B may be an operating temperature of the memory device 110B during an operation of the memory device 110B.

For example, the voltage generation circuit 731 may generate the bias voltage VB, inversely proportional to the temperature of the memory device 110B. Accordingly, the voltage generation circuit 731 may be referred to as a complementary to absolute temperature (CTAT) circuit.

For some examples, the voltage generation circuit 731 may generate the bias voltage VB, proportional to the temperature of the memory device 110B. Accordingly, the voltage generation circuit 731 may be referred to as a proportional to absolute temperature (PTAT) circuit.

The LDO regulator 732 may output the bias voltage VB generated from the voltage generation circuit 731 within a predetermined offset range.

For example, the LDO regulator 732 may compare a power supply voltage VDD with the bias voltage VB generated from the voltage generation circuit 731 to output the bias voltage VB such that the bias voltage VB corresponding to the control signals CTRL2 is applied to a gate electrode (gate terminal or gate) of each of a selected number of first auxiliary transistors. In example embodiments, the control logic circuit 730 may provide the control signals CTRL2 having the bias voltage VB to a gate electrode of each of a selected number of first auxiliary transistors.

For example, when the power supply voltage VDD is 1V, the bias voltage VB may have a value between about 500mV and about 700mV.

Referring to FIG. 9, a voltage generation circuit 731A according to an example embodiment may include a first P-channel metal-oxide-semiconductor (PMOS) transistor PTR1, a second PMOS transistor PTR2, a first transistor T1, a second transistor T2, a first resistor R1, and a first comparator comp1.

The voltage generation circuit 731A illustrated in FIG. 9 may be understood as an example of the voltage generation circuit 731 illustrated in FIG. 8.

For example, the voltage generation circuit 731A may include the first PMOS transistor PTR1 and the first transistor T1 connected in series between a power supply voltage VDD and a ground voltage VSS.

In addition, the voltage generation circuit 731A may include the second PMOS transistor PTR2, the first resistor R1, and the second transistor T2 connected in series between the power supply voltage VDD and the ground voltage VSS.

In addition, the voltage generation circuit 731A may include the first comparator comp 1 having two input terminals, respectively connected to a first node N1 between the first PMOS transistor PTR1 and the first transistor T1 and a second node N2 between the second PMOS transistor PTR2 and the first resistor R1.

The first comparator comp1 may have an output terminal connected to a third node N3 connected to gate electrodes, which may be referred to as gate terminals or gates, of the first PMOS transistor PTR1 and the second PMOS transistor PTR2.

According to an example embodiment, the first comparator comp1 may output a result of comparing a voltage at the first node N1 with a voltage of the second node N2. For example, the first comparator comp1 may compare the voltage at the first node N1 with the voltage at the second node N2 to output a bias voltage VBa through the third node N3.

Furthermore, the control logic circuit 730 or the LDO regulator 732 may apply the bias voltage VBa corresponding to the control signals CTRL2, generated from the voltage generation circuit 731A, to gate electrodes, which may be referred to as gate terminals or gates, of at least a portion of a plurality of first auxiliary transistors ATR1s. For example, the LDO regulator 732 may apply the bias voltage VBa within a predetermined offset range to the gate electrodes of at least a portion of the plurality of first auxiliary transistors ATR1s based on the bias voltage VBa from the voltage generation circuit 731A.

For example, the control logic circuit 730 may provide the control signals CTRL2 having the bias voltage VBa to a gate electrode, which may be referred to as a gate terminal or gate, of each of a first number of first auxiliary transistors ATR1s, among the plurality of first auxiliary transistors ATR1s, in response to an operation command for a (1-1)-th magnetic memory cell MC11.

The bias voltage VBa may be proportional to a temperature of the memory device 110B. Therefore, the voltage generation circuit 731A illustrated in FIG. 9 may be referred to as a proportional to absolute temperature (PTAT) circuit.

Referring to FIG. 10, according to an example embodiment, a voltage generation circuit 731B may include an operation current generation circuit, a first generation circuit, and a second generation circuit.

For example, the voltage generation circuit 731B may include an operation current generation circuit 901 generating an operation current Ia. The operation current Ia may include a read current or a write current.

In addition, the voltage generation circuit 731B may include a first generation circuit 911 generating a first bias voltage VB1. The first generation circuit 911 may be understood to have substantially the same configuration as the voltage generation circuit 731A illustrated in FIG. 9. Therefore, redundant descriptions will be omitted to avoid repetition.

Also, the voltage generation circuit 731B may include a second generation circuit 912 generating a second bias voltage VB2.

The second generation circuit 912 may include a third PMOS transistor PTR3 and a second resistor R2 connected in series between the power supply voltage VDD and the ground voltage VSS.

Also, the second generation circuit 912 may include a second comparator Comp2 having two input terminals, respectively connected to a fourth node N4 between the third PMOS transistor PTR3 and the second resistor R2 and the first node N1.

The second comparator Comp2 may have an output terminal connected to a fifth node N5 connected to a gate electrode, which may be referred to as a gate terminal or gate, of the third PMOS transistor PTR3.

According to an example embodiment, the second comparator Comp2 may output a result of comparing a voltage at the first node N1 with a voltage at the fourth node N4. For example, the second comparator Comp2 may compare the voltage at the first node N1 with the voltage at the fourth node N4 to output a second bias voltage VB2 through the fifth node N5.

The second bias voltage VB2 may be understood to be in inverse proportional to a temperature of the memory device 110B. Therefore, the second generation circuit 912 may be referred to as a CTAT circuit.

Furthermore, the control logic circuit 730 may provide the control signals CTRL2 having a voltage, obtained by combining the first bias voltage VB1 and the second bias voltage VB2 at a predetermined ratio, to gate electrodes, which may be referred to as gate terminals or gates, of at least a portion of the plurality of first auxiliary transistors ATR1s. For example, the control logic circuit 730 may provide the control signals CTRL2 having the voltage through the voltage generation circuit 731B or the LDO regulator 732.

For example, the control logic circuit 730 may apply a voltage, obtained by combining the first bias voltage VB1 and the second bias voltage VB2 at a preset ratio, to a gate electrode, which may be referred to as a gate terminal or gate, of each of a first number of first auxiliary transistors ATR1s, among the plurality of first auxiliary transistors ATR1s, in response to an operation command for a (1-1)-th magnetic memory cell MC11. For example, the control logic circuit 730 may provide the control signals CTRL2 having the voltage obtained by combining the first bias voltage VB1 and the second bias voltage VB2 at the preset ratio to the gate electrode of each of the first number of first auxiliary transistors ATR1s.

For example, the control logic circuit 730 may generate the bias voltage VB by combining the first bias voltage VB1 and the second bias voltage VB2 at a ratio of 2:1.

Furthermore, the control logic circuit 730 may apply the generated bias voltage VB to a gate electrode, which may be referred to as a gate terminal or gate, of each of a first number of first auxiliary transistors ATR1s among the plurality of first auxiliary transistors ATR1s.

For example, referring to the above-described configuration, the control logic circuit 730 may apply the bias voltage VB varying depending on the temperature of the memory device 110B to a gate electrode, which may be referred to a gate terminal or gate, of each of the auxiliary transistors corresponding to the selected wordline.

As a result, the memory device 110B (or the memory system 100) according to an example embodiment may prevent performance degradation caused by a difference in the temperature of the memory device 110B.

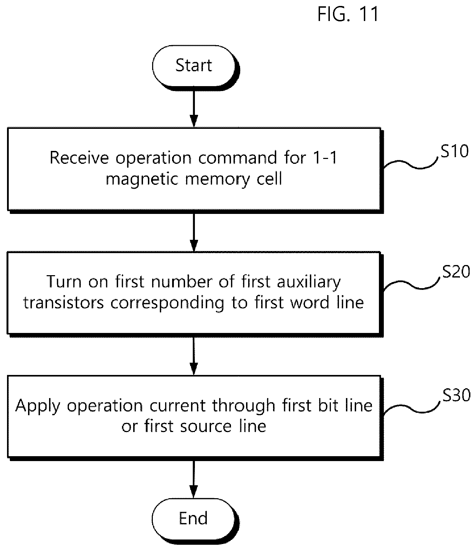

FIG. 11 is a flowchart illustrating a method of operating a memory device according to an example embodiment.

Referring to FIG. 11, the control logic circuit 130 (or the memory device 110) according to an example embodiment may turn on a first number of first auxiliary transistors corresponding to the first wordline WL1 in response to an operation command for the (1-1)-th magnetic memory cell MC11.

In operation S10, the control logic circuit 130 according to an example embodiment may receive the operation command for the (1-1)-th magnetic memory cell MC11.

For example, the control logic circuit 130 may receive a read command or a write command for the (1-1)-th magnetic memory cell MC11 from a memory controller (for example, the memory controller 120 of FIG. 1).

The control logic circuit 130 may receive an operation command for the (1-1)-th magnetic memory cell MC11 connected to a first bitline BL1, a first source line SL1, and a first wordline WL1.

For example, the control logic circuit 130 may receive an address corresponding to the (1-1)-th magnetic memory cell MC11 and a read command from the memory controller.

In operation S20, the control logic circuit 130 according to an example embodiment may turn on a first number of first auxiliary transistors corresponding to the first wordline WL1.

The control logic circuit 130 may turn on the first number of first auxiliary transistors corresponding to the first wordline WL1, among the plurality of first auxiliary transistors ATR1s connected to the first bitline BL1 and the first source line SL1, in response to the operation command for the (1-1)-th magnetic memory cell MC11.

The plurality of first auxiliary transistors ATR1s may be connected in parallel to each other between the first bitline BL1 or the first source line SL1 and the ground.

For example, the control logic circuit 130 may identify the first wordline WL1, the first bitline BL1, and the first source line SL1, activated based on an operation command, in response to the operation command for the (1-1)-th magnetic memory cell MC11. For example, the control logic circuit 130 identify the first wordline WL1, the first bitline BL1, and the first source line SL1, activated based on the first operation command of operation S10.

Furthermore, the control logic circuit 130 may turn on the first number of first auxiliary transistors corresponding to the first wordline WL1, among the plurality of first auxiliary transistors ATR1s connected to the first bitline BL1 and the first source line SL1.

For example, the control logic circuit 130 may turn a single first auxiliary transistor corresponding to the first wordline WL1, among the plurality of first auxiliary transistors ATR1s, in response to a write command for the (1-1)-th magnetic memory cell MC11.

In operation S30, the control logic circuit 130 according to an example embodiment may apply an operation current through the first bitline BL1 or the first source line SL1. The operation current may be applied according to the operation command of operation S10.

For example, the control logic circuit 130 may apply an operation current to the (1-1)-th magnetic memory cell MC11 through the first bitline BL1 or the first source line SL1.

For example, when the operation command includes a read command, the control logic circuit 130 may apply a read current to the (1-1)-th magnetic memory cell MC11 through the first bitline BL1. The control logic circuit 130 may apply the read current to the selected first bitline BL1 through the column decoder 152 using the input/output driver 140.

Also, the control logic circuit 130 may measure a resistance value of the first variable resistor 310, included in the (1-1)-th magnetic memory cell MC11, based on a current measured through the first source line SL1. Furthermore, the control logic circuit 130 may compare the resistance value of the first variable resistor 310 with a reference resistance Rref to read data stored in the (1-1)-th magnetic memory cell MC11.

For example, when the operation command includes a write command, the control logic circuit 130 may apply a write current to the (1-1)-th magnetic memory cell MC11 through the first bitline BL1 or the first source line SL1.

Also, the control logic circuit 130 may apply a driving voltage through the first wordline WL1 in a state in which the first number of first auxiliary transistors is turned on.

For example, the control logic circuit 130 may perform a read operation or a write operation on the (1-1)-th magnetic memory cell MC11 in a state in which the first number of first auxiliary transistors are turned on.

Furthermore, the control logic circuit 130 may turn on a second number of first auxiliary transistors, among the plurality of first auxiliary transistors ATR1s, in response to an operation command for a (1-2)-th magnetic memory cell MC12.

The (1-2)-th magnetic memory cell MC12 may be connected to the first bitline BL1, the first source line SL1, and the second wordline WL2. Also, the second number may be referred to as being larger than the first number.

Also, a resistance along an electrical path from the input/output driver 140 to the (1-1)-th magnetic memory cell MC11 may be referred to as being higher than a resistance along an electrical path from the input/output driver 140 to the (1-2)-th magnetic memory cell MC12.

Referring to the above-described configuration, the control logic circuit 130 may turn on the number of auxiliary transistors corresponding to a wordline, among auxiliary transistors connected to a specific magnetic memory cell, in response to an operation command for the specific magnetic memory cell.

For example, the control logic circuit 130 may turn on a relatively large number of first auxiliary transistors in response to an operation command for a magnetic memory cell having a relatively high resistance along the electrical path connected from the input/output driver 140.

Accordingly, the control logic circuit 130 may significantly reduce a variation in operational performance caused by a difference in locations of the magnetic memory cells when performing a read or write operation on the memory cell array 111.

As a result, the control logic circuit 130 may significantly reduce performance degradation of the memory device 110 caused by the difference in the locations of the magnetic memory cells.

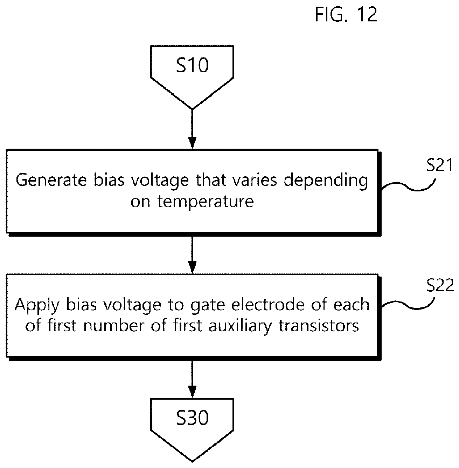

FIG. 12 is a flowchart illustrating a method of turning on at least a portion of a plurality of first auxiliary transistors by a control logic circuit according to an example embodiment.

Referring to FIG. 12, the control logic circuit 730 according to an example embodiment may apply the bias voltage VB to a gate electrode, which may be referred to as a gate terminal or gate, of each of a first number of first auxiliary transistors.

For example, the control logic circuit 730 may apply the bias voltage VB, varying depending on a temperature of the memory device 110, to a gate electrode, which may be referred to as a gate terminal or gate, of each of the first number of first auxiliary transistors.

In operation S21, the control logic circuit 730 according to an example embodiment may generate the bias voltage VB, varying depending on the temperature of the memory device 110, using the voltage generation circuit 731.

For example, the voltage generation circuit 731 may be referred to as a CTAT circuit generating a voltage (or current) decreasing as the temperature of the memory device 110 increases, but example embodiments are not limited thereto. For example, the voltage generation circuit 731 may be referred to as a PTAT circuit generating a voltage (or current) increasing as the temperature of the memory device 110 increases.

In operation S22, the control logic circuit 730 according to an example embodiment may apply the bias voltage VB to the gate electrode, which may be referred to as a gate terminal or gate, of each of the first number of first auxiliary transistors.

For example, the bias voltage VB may be understood to have a value between about 500mV and about 700mV.

Referring to the above-described configuration, the control logic circuit 730 may provide the control signals CTRL2 having the bias voltage VB, varying depending on the temperature of the memory device 110, to the gate electrodes, which may be referred to as gate terminals or gates, of each of the auxiliary transistors corresponding to the wordline.

As a result, the memory device 110 (or the memory system 100) according to an example embodiment may prevent performance degradation caused by a difference in the temperature of the memory device 110.

As described above, the control logic circuit 130 according to an example embodiment may turn on the number of auxiliary transistors corresponding to a wordline, among auxiliary transistors connected to a specific magnetic memory cell, in response to an operation command for the specific magnetic memory cell.

For example, the control logic circuit 130 may turn on a relatively large number of first auxiliary transistors in response to an operation command for a magnetic memory cell having a relatively large resistance along an electrical path connected from the input/output driver 140.

The control logic circuit 130 may turn on a relatively small number of first auxiliary transistors in response to an operation command for a magnetic memory cell having a relatively small resistance along the electrical path connected from the input/output driver 140.

Accordingly, the memory device 110 according to an example embodiment may significantly reduce a variation in operational performance caused by a difference in locations of magnetic memory cells. As a result, the control logic circuit 130 may significantly reduce performance degradation of the memory device 110 caused by the difference in the locations of the magnetic memory cells.

Furthermore, the control logic circuit 730 according to an example embodiment may apply the bias voltage VB, varying depending on the temperature of the memory device 110, to a gate electrode, which may be referred to as a gate terminal or gate, of each of the auxiliary transistors corresponding to the wordline.

As a result, the memory device 110 (or the memory system 100) according to an example embodiment may prevent performance degradation caused by the difference in the temperature of the memory device 110.

As set forth above, a memory device according to example embodiments may significantly reduce performance degradation caused by a difference in locations of magnetic memory cells and/or a difference in temperature of the memory device.

While example embodiments have been shown and described above, it will be apparent to those skilled in the art that modifications and variations could be made without departing from the scope of the present inventive concept as defined by the appended claims.

## Claims

1. A memory device (110) comprising:
a memory cell array **(111)** including a plurality of magnetic memory cells connected to a plurality of wordlines, a plurality of bitlines and a plurality source lines;
a plurality of auxiliary transistors (ATR1) connected in parallel between a first bitline (BL1) of the plurality of bitlines or a first source line (SL1) of the plurality of source lines, and a ground; and
a control logic circuit (130) connected to a gate electrode of each of the plurality of auxiliary transistors (ATR1),
wherein the plurality of magnetic memory cells include a plurality of first magnetic memory cells connected to the plurality of wordlines, the first bitline (BL1) and the first source line (SL1), and
wherein the control logic circuit (130) is configured to turn on a first number of auxiliary transistors corresponding to a first wordline (WL1) of the plurality of wordlines, among the plurality of auxiliary transistors (ATR1), in response to an operation command for a first magnetic memory cell (MC11) connected to the first wordline (WL1), among the plurality of first magnetic memory cells.

2. The memory device (100) of claim 1, further comprising:
a row decoder (151) connected to the memory cell array **(111)** through the plurality of wordlines;
a column decoder (152) connected to the memory cell array (111) through the plurality of bitlines and the plurality of source lines; and
an input/output driver (140) configured to apply an operation current to a bitline or a source line, selected through the column decoder (152), among the plurality of bitlines and the plurality of source lines,
wherein the control logic circuit (130) is configured to apply an operation current to the first bitline (BL1) from the input/output driver (140) in a state in which the first number of the auxiliary transistors are turned on.

3. The memory device (100) of claim 2, wherein the control logic circuit (130) is configured to turn on a second number of auxiliary transistors, among the plurality of auxiliary transistors (ATR1), corresponding to a second wordline (WL2) of the plurality of wordlines, in response to an operation command for a second magnetic memory cell (MC12) connected to the second wordline (WL2), among the plurality of first magnetic memory cells, and
wherein the second number is smaller than the first number.

4. The memory device (100) of claim 2 or 3, wherein the control logic circuit (130) is configured to apply a driving voltage to the first wordline (WL1) from the row decoder (151) in a state in which the first number of auxiliary transistors are turned on.

5. The memory device (100) of any of claims 2 to 4, wherein the input/output driver (140) further comprises:
a sense amplifier (141) configured to read data stored in the first magnetic memory cell by detecting a difference between a voltage of the first source line (SL 1) and a reference voltage, during a read operation on the first magnetic memory cell; and
a write driver (142) configured to transmit a write current to the column decoder (152) based on a control signal (CTRL1) transmitted from the control logic circuit (130), during a write operation on the first magnetic memory cell.

6. The memory device (100) of any preceding claim, wherein the control logic circuit (730) further comprises:
a voltage generation circuit (731) configured to generate a bias voltage (VB) varying depending on a temperature of the memory device (100),
wherein the control logic circuit (730) is configured to provide control signals having the bias voltage (VB) to a gate electrode of each of the first number of auxiliary transistors in response to the operation command for the first magnetic memory cell (MC11).

7. The memory device (100) of claim 6, wherein the voltage generation circuit (731B) comprises:
a first generation circuit (911) configured to generate a first bias voltage (VB1), proportional to the temperature; and
a second generation circuit (912) configured to generate a second bias voltage (VB2), inversely proportional to the temperature, and
the control logic circuit (730) is configured to provide the control signals having the bias voltage, obtained by combining the first bias voltage (VB1) and the second bias voltage (VB2) at a predetermined ratio, to the gate electrode of each of the first number of auxiliary transistors.

8. The memory device (100) of claim 6, wherein the control logic circuit (730) further comprises:
a low-dropout, LDO, regulator (732) configured to compare a power supply voltage (VDD) with the bias voltage (VB) and output the bias voltage (VB) within a predetermined offset range.

9. The memory device (100) of any preceding claim, wherein the first magnetic memory cell (MC11) includes:
a first variable resistance element (310) including a first magnetic layer (311), a second magnetic layer (312), and a tunnel layer (313) disposed between the first magnetic layer (311) and the second magnetic layer (312), and
wherein the first magnetic memory cell (MC11) is configured to store a resistance value depending on a magnetization direction of the first magnetic layer **(311)** and a magnetization direction of the second magnetic layer (312) formed in response to a current being applied through the first bitline (BL1).

10. The memory device (100) of any preceding claim, wherein each of the plurality of auxiliary transistors (ATR1) is an N-channel metal-oxide-semiconductor, NMOS, transistor.

11. A method of operating a memory device (100), the method comprising:
receiving (S10) an operation command at the memory device (100) for a first magnetic memory cell connected to a first bitline (BL1), a first source line (SL1), and a first wordline (WL1);
turning (S20) on a first number of auxiliary transistors, connected in parallel between the first bitline (BL1) or the first source line (SL1) and a ground, corresponding to the first wordline (WL1), among a plurality of auxiliary transistors (ATR1); and
applying (S30) an operation current through the first bitline (BL1) or the first source line (SL1).

12. The method of claim 11, wherein the turning (S10) on of the first number of auxiliary transistors comprises:
generating (S21) a bias voltage (VB), varying depending on a temperature of the memory device (100), from a voltage generation circuit (731) in response to the operation command; and
applying (S22) the bias voltage (VB) to a gate electrode of each of the first number of auxiliary transistors.

13. The method of claim 11 or 12, wherein the applying (S30) of the operation current through the first bitline (BL1) or the first source line (SL1) comprises:
selecting the first bitline (BL1) from among a plurality of bitlines from a column decoder (152) in response to the first number of auxiliary transistors being turned on; and
applying an operation current to the first bitline (BL1) through an input/output driver (140) connected to the column decoder (152).

14. The method of any of claims 11 to 13, further comprising:
turning on a second number of auxiliary transistors, among the plurality of auxiliary transistors (ATR1), in response to an operation command for a second magnetic memory cell (MC12) connected to the first bitline (BL1) or the first source line (SL1), and a second wordline (WL2),
wherein the second number is smaller than the first number.

15. The method of any of claims 11 to 14, further comprising:
applying a driving voltage through the first wordline (WL1) in a state in which the first number of auxiliary transistors are turned on.
